(19) Europäisches Patentamt
European Patent Office
Office européen des brevets

(11) **EP 4 020 335 A2**

(12) **DEMANDE DE BREVET EUROPEEN**

(43) Date de publication:
**29.06.2022 Bulletin 2022/26**

(21) Numéro de dépôt: **21216127.7**

(22) Date de dépôt: **20.12.2021**

(51) Classification Internationale des Brevets (IPC):
***G06N 10/40*** *(2022.01)*

(52) Classification Coopérative des Brevets (CPC):
**G06N 10/40**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **23.12.2020 FR 2014083**

(71) Demandeurs:
• **Commissariat à l'Energie Atomique et aux Energies
Alternatives
75015 Paris (FR)**
• **Centre national de la recherche scientifique
75016 Paris (FR)**

(72) Inventeurs:
• **MORTEMOUSQUE, Pierre-André
38054 Grenoble Cedex 09 (FR)**
• **MEUNIER, Tristan
38000 Grenoble (FR)**
• **BERTRAND, Benoit
38160 Saint-Marcellin (FR)**
• **JADOT, Baptiste
38000 Grenoble (FR)**
• **URDAMPILLETA, Matias
38000 Grenoble (FR)**

(74) Mandataire: **Cabinet Camus Lebkiri
25 rue de Maubeuge
75009 Paris (FR)**

(54) **PROCÉDÉ DE DÉTERMINATION DE LA POSITION DU RÉGIME TOTALEMENT ISOLÉ D'UN QUBIT DE SPIN ET PROCÉDÉ DE MANIPULATION D'AU MOINS UN QUBITS DE SPIN**

(57) Un aspect de l'invention concerne un procédé de manipulation d'au moins un groupe de boites quantiques d'une matrice de boites quantiques, dit groupe cible, chaque groupe cible comprenant au moins une boite quantique et contenant au moins une particule chargée (PC), la matrice de boites quantiques étant configurée pour être connectée à au moins un réservoir de particules chargées (PC), chaque groupe cible étant défini par une barrière de potentiel, chaque particule chargée (PC) étant porteuse d'une charge et d'un spin, le procédé comprenant, pour chaque groupe cible : au moins une étape d'isolement total du groupe cible relativement aux autres boites quantiques de la matrice, la barrière de potentiel séparant le groupe cible des boites quantiques de la matrice adjacentes audit groupe cible étant configurée de sorte que la ou les particules chargées (PC) contenues dans le groupe cible ne peuvent pas traverser la barrière de potentiel pour se déplacer vers les boites quantiques adjacentes au groupe cible ou au réservoir de particules chargées même lorsqu'une telle transition est autorisée d'un point de vue énergétique, dit régime totalement isolé ; une étape de manipulation durant laquelle le groupe cible est maintenu dans le régime totalement isolé.

[Fig. 4B]

EP 4 020 335 A2

## Description

## DOMAINE TECHNIQUE DE L'INVENTION

Le domaine technique de l'invention est celui de l'informatique quantique.

La présente invention concerne un procédé de manipulation d'un qubit de spin défini à l'aide de particules chargées piégées dans des boites quantiques et en particulier un procédé dans lequel un ou plusieurs qubits sont manipulés alors qu'ils se trouvent dans un régime dit totalement isolé relativement aux autres qubits, où l'état de charge du ou des qubits de spins n'est pas susceptible de changer.

## ARRIERE-PLAN TECHNOLOGIQUE DE L'INVENTION

L'informatique quantique a connu un fort développement cette dernière décennie. Parmi les différentes technologies proposées, les technologies compatibles avec les techniques de fabrication CMOS semblent les plus prometteuses, car elles s'appuient sur des techniques de fabrication et de caractérisation maîtrisées.

Un dispositif compatible CMOS est par exemple décrit dans le document EP 3 401 848 A1. Le dispositif décrit dans ce document permet d'obtenir une matrice de boites quantiques. Un système de boites quantiques contenant des particules chargées (électron ou trou) correspond à un qubit de spin où l'information quantique est encodée dans leurs degrés de liberté de spin. Il est possible de coupler les boites quantiques entres-elles ou avec des réservoirs. La présence des particules chargées est inférée par des systèmes de détection sensibles à la présence des particules chargées, par exemple par des électromètres locaux. Les potentiels électrostatiques permettant de former les boites quantiques et de contrôler leur potentiel sont obtenus à partir de séries de grilles locales. A l'aide des potentiels appliqués sur les grilles, on réalise des portes quantiques sur les qubits de spin.

Afin d'utiliser ce type de dispositif, il est généralement nécessaire d'effectuer une calibration afin d'identifier les différents points de fonctionnement utile à la mise en œuvre de portes quantiques. Un tel procédé de calibration est par exemple décrit dans le document US2020/0127096 A1 pour un dispositif similaire à celui décrit dans le document EP 3 401 848 A1. Dans ce procédé de calibration, le nombre de porteurs de charge dans chaque boite quantique est fixé par le régime de Coulomb. Autrement dit, la particule chargée d'une première boite quantique ne peut pas aller dans une deuxième boite quantique voisine car il faudrait pour cela « payer » une énergie, dite énergie de charge, afin de pouvoir effectuer une telle transition. Pour plus de détail sur le blocage de Coulomb, le lecteur pourra se référer par exemple au chapitre 3 de Nazarov, Y., & Blanter, Y. (2009) ; Quantum Transport: Introduction to Nanoscience ; Cambridge: Cambridge University Press.

Ce régime de Coulomb, bien que jugé nécessaire pour permettre la manipulation des qubits, n'est pas sans inconvénient. Notamment, l'énergie de charge garantissant un nombre de charges fixes dans chaque boite quantique peut être comparable aux énergies mises en œuvre pour la manipulation des qubits, si bien que l'état de charge des boîtes quantiques que l'on souhaite pourtant fixe peut être amené à changer de manière non contrôlée lors de cette manipulation. Ces effets indésirables sont délétères pour le calcul quantique.

Il existe donc un besoin d'un procédé qui permette de manipuler les qubits cibles tout en limitant au maximum les modifications des états de charge des boîtes quantiques lors de ces manipulations.

## RESUME DE L'INVENTION

L'invention offre une solution aux problèmes évoqués précédemment, en proposant un procédé dans lequel les particules chargées sont manipulées alors qu'elles sont dans un régime totalement isolé relativement aux autres particules chargées.

Pour cela, un premier aspect de l'invention concerne un procédé de manipulation d'au moins un groupe de boites quantiques d'une matrice de boites quantiques, dit groupe cible, charque groupe cible comprenant au moins une boite quantique et contenant au moins une particule chargée, la matrice de boites quantiques étant configurée pour être connectée à au moins un réservoir de particules chargées, chaque groupe cible étant défini par une barrière de potentiel, chaque particule chargée étant porteuse d'une charge et d'un spin, le procédé comprenant, pour chaque groupe cible :

- au moins une étape d'isolement total du groupe cible relativement aux autres boites quantiques de la matrice, la barrière de potentiel séparant le groupe cible des boites quantiques de la matrice adjacentes audit groupe cible étant configurée de sorte que la ou les particules chargées contenues dans le groupe cible ne peuvent pas traverser la barrière de potentiel pour se déplacer vers les boites quantiques adjacentes au groupe cible ou au réservoir de particules chargées même lorsqu'une telle transition est autorisée d'un point de vue énergétique, dit régime totalement isolé ;

- une étape de manipulation durant laquelle le groupe cible est maintenu dans le régime totalement isolé.

Ainsi, durant l'étape de manipulation, les boites quantiques d'un même groupe cible, bien que couplés entre elles, sont dans un régime totalement isolé relativement aux autres boites quantiques ce qui permet d'assurer la conservation de la charge au niveau de chaque groupe cible lors de l'étape de manipulation.

De même, lorsque l'étape de manipulation comprend une opération de conversion spin/charge, la ou les boites quantiques contenant la ou les particules chargées dont l'état de spin est à convertir et la ou les boites quantiques utilisées pour ladite conversion, bien que couplés entre elles, sont dans un régime totalement isolé relativement aux autres boites quantiques ce qui permet d'assurer la conservation de la charge du système constitué par ces deux sous-groupes de boites quantiques lors de l'opération de conversion.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Dans un mode de réalisation, l'étape de manipulation comprend au moins une opération cohérente.

Dans un mode de réalisation, l'étape de manipulation comprend au moins une opération de contrôle électrostatique.

Dans un mode de réalisation, l'étape de manipulation comprend au moins une opération de conversion spin/charge réalisée sur au moins un groupe cible, ledit groupe cible étant divisé en un premier sous-groupe de boites quantiques et un deuxième sous-groupe de boites quantiques, opération durant laquelle l'état de spin de la ou des particules chargées contenues dans le premier sous-groupe de boites quantiques est converti, à l'aide du deuxième sous-groupe de boites quantiques en un état de charge du groupe cible, le procédé comprenant en outre une étape de détermination de l'état de charge du groupe cible de sorte à déterminer l'état de spin de la ou des particules chargées contenues dans le premier sous-groupe de boites quantiques.

Dans un mode de réalisation l'étape de détermination de l'état de charge est précédée d'une étape d'isolement total de chaque sous-groupe de boites quantiques du groupe cible de boites quantiques de sorte que l'étape de détermination de l'état de charge se fait alors que le premier sous-groupe et le deuxième sous-groupe du groupe cible de boite quantique est dans un régime totalement isolé.

Ainsi, durant l'étape de lecture de l'état de charge, chaque sous-groupe est dans un régime totalement isolé, ce qui permet de s'assurer que l'état de charge du sous-groupe impliqué dans l'étape de conversion précédemment évoquée est identique à l'état de charge de ce sous-groupe de boites quantiques à l'issue de l'opération de conversion spin/charge.

Dans un mode de réalisation, durant l'étape d'isolement, l'étape de manipulation et/ou, le cas échéant, l'étape de détermination de l'état de charge, les boites quantiques n'appartenant pas à un groupe cible sont dans un régime totalement isolé. Ainsi, durant ces étapes, et en particulier l'étape de manipulation, les boites quantiques non manipulées sont dans le régime totalement isolé ce qui garantit que leur état de charge reste figé et ne sera pas modifié par les étapes de manipulation des groupes cibles.

Un deuxième aspect de l'invention concerne un procédé de détermination de la position du régime totalement isolé entre une première boite quantique et une deuxième boite quantique, la configuration du système constitué par la première boite quantique et la deuxième boite quantique pouvant être caractérisée par un premier paramètre $\Gamma$ relatif à la barrière de potentiel séparant les deux boites quantiques du système et par un deuxième paramètre $\varepsilon$ relatif à la différence en énergie entre l'état fondamental de la première boite quantique et l'état fondamental de la deuxième boite quantique, le premier et le deuxième paramètres pouvant être modifiés à l'aide d'au moins deux tensions appliquées sur des grilles, ledit le système est caractérisé par l'état de charge (1,1), l'état de charge (0,2) et l'état de charge (2,0) où l'état de charge $(n_{QD1}, n_{QD2})$ correspond à un état de charge $n_{QD1}$ pour la première boite quantique et un état de charge $n_{QD2}$ pour la deuxième boite quantique, le procédé comprenant, pour une pluralité de configurations finales :

-   pour une pluralité de configuration initiale correspondant à une distribution d'état de charge connue, dite distribution des états de charge initiale :

    ▪ une étape d'initialisation du système dans une première configuration correspondant à la configuration initiale considérée ;

    ▪ une étape de diminution du premier paramètre $\Gamma$, le système étant dans une deuxième configuration, dite configuration intermédiaire à l'issue de cette étape, la valeur du premier paramètre $\Gamma$ de la configuration intermédiaire étant égale à la valeur du premier paramètre $\Gamma$ de la configuration finale considéré ;

    ▪ une étape de variation du deuxième paramètre $\varepsilon$, la valeur du premier paramètre étant conservée lors de cette étape, le système étant dans une troisième configuration, correspondant à la configuration finale considérée à l'issue de cette étape ;

    ▪ une étape de détermination de l'état de charge du système dans la configuration finale ;

-   une étape de détermination de la distribution des états de charge mesurés dans la configuration finale ;

-   une étape de comparaison de la distribution des états de charge initiale à la distribution des états de charges mesurés dans la configuration finale, la valeur du premier paramètre $\Gamma$ de la configuration finale correspondant à un régime totalement isolé si les deux distributions sont sensiblement identiques.

La notation adoptée pour les états de charge ne doit pas être interprétée de manière limitative, mais a été choisie afin de faciliter la compréhension de l'invention. Ainsi, l'état de charge (1,1) doit être compris comme l'état de charge (n,n) où n est un nombre de particules chargées pour lequel le spin résultant est un spin ½. Suivant cette même notation, l'état de charge (2,0) (respectivement (0,2)) doit être compris comme l'état de charge (n+1 ,n-1) (respectivement (n-1 ,n+1 )).

Un troisième aspect de l'invention concerne un dispositif quantique comprenant une matrice de boites quantiques et des moyens configurés pour mettre en œuvre un procédé selon un premier ou un deuxième aspect de l'invention.

Un quatrième aspect de l'invention concerne un programme d'ordinateur comprenant des instructions qui, lorsque le programme est exécuté par un ordinateur, conduisent celui-ci à mettre en œuvre le procédé selon un premier ou un deuxième aspect de l'invention.

Un cinquième aspect de l'invention concerne un support de données lisible par ordinateur, sur lequel est enregistré le programme d'ordinateur selon un quatrième aspect de l'invention.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

La [Fig. 1] montre un ordinogramme d'un procédé selon l'invention.

La [Fig. 2] montre une représentation schématique d'une matrice de boites quantiques.

La [Fig. 3] montre une représentation schématique d'une boite quantique contenant une particule chargée.

La [Fig. 4A] et [Fig. 4B] montrent une représentation schématique de deux boites quantiques dans un régime totalement isolé l'un relativement à l'autre.

La [Fig. 5] montre une représentation schématique d'une matrice de boites quantiques sur laquelle sont représentés trois groupes cibles de boites quantiques.

La [Fig. 6] montre une représentation schématique d'un groupe cible comprenant deux boites quantiques.

La [Fig. 7A] et la [Fig. 7B] illustrent le principe de la conversion spin/charge.

La [Fig. 8] montre un ordinogramme d'un procédé selon un deuxième aspect de l'invention.

La [Fig. 9] montre une représentation schématique d'un diagramme de stabilité d'un système comprenant deux boites quantiques.

La [Fig. 10] montre une représentation schématique d'une pluralité de configurations finales dans un diagramme de stabilité d'un système comprenant deux boites quantiques.

La [Fig. 11] montre une représentation schématique d'une pluralité de configurations initiales dans un diagramme de stabilité d'un système comprenant deux boites quantiques avec la densité des états de charge initiales correspondante.

Les [Fig. 12] à [Fig. 14] montre une représentation schématique des étapes du procédé selon un deuxième aspect de l'invention.

La [Fig. 15] montre la probabilité de conserver l'état initial dans un procédé selon un deuxième aspect de l'invention en fonction de la valeur du premier paramètre.

La [Fig. 16] montre la probabilité d'être dans l'état de charge (1,1) en fonction du temps d'attentes dans un procédé selon un deuxième aspect de l'invention.

La [Fig. 17] montre une représentation schématique d'une matrice de boites quantiques lors de la mise en œuvre d'un procédé selon un deuxième aspect de l'invention.

La [Fig. 18] montre une représentation schématique d'une matrice de boites quantiques lors de la mise en œuvre d'un procédé selon un premier aspect de l'invention.

Les [Fig. 19] et [Fig. 20] montrent la position d'un système dans un diagramme de stabilité qui lui est associé lors de la mise en œuvre d'un procédé selon un premier aspect de l'invention.

**DESCRIPTION DETAILLEE**

Sauf précision contraire, un même élément apparaissant sur des figures différentes présente une référence unique.

Dans la suite, l'état de charge d'un système (ou d'un groupe) comprenant une pluralité de boîtes quantiques QD sera représenté par la notation suivante $(n_1, n_2 ..., n_N)$ avec ni la charge associée à ième boite quantique QD du système. Par exemple, l'état de charge d'un système comprenant deux boites quantiques QD ayant chacune une charge de 1 sera notée (1,1). Par ailleurs, pour mémoire, un qubit de spin caractérise le degré de liberté de spin d'une ou plusieurs particules chargées PC. Pour définir un qubit de spin il faut donc piéger une ou plusieurs particules chargées PC dans une ou plusieurs boîtes quantiques QD.

Par ailleurs, on entend par partiellement isolé, le fait qu'une ou plusieurs boites quantiques QD sont isolées des réservoirs de porteurs de charge de sorte qu'aucune charge ne peut passer d'une boite quantique QD à un réservoir ou bien encore d'un réservoir à une boite quantique QD. Cela signifie donc que la charge totale au niveau des boites quantiques QD est invariable, mais la charge au niveau de chaque boite quantique QD peut changer. C'est en particulier la configuration utilisée dans les documents de l'état de la technique.

Comme cela a déjà été souligné, l'un des inconvénients de cette configuration est la possibilité pour l'état de charge d'une ou plusieurs boites quantiques QD de changer lors de l'étape ou des étapes de manipulation. Par exemple, si le système comporte cinq boites quantiques QD contenant chacune une particule chargée PC et que l'on souhaite manipuler les particules chargées PC contenues dans un couple de boites quantiques QD initialement dans l'état de charge (1,1), il est possible que cet état de charge soit modifié par un transfert d'une particule chargée PC d'une boite quantique QD contenant une particule chargée PC non manipulée vers une boite quantique QD du couple de boites quantiques QD contenant les particules PC chargées manipulées, l'état de charge du couple de boites quantiques contenant les particules chargées PC manipulées devenant alors (2,1), au lieu de rester dans l'une des configurations (1,1), (0,2) ou (2,0). Il est donc utile de mettre en œuvre un procédé de manipulation permettant de s'affranchir de ce risque.

**Procédé de manipulation selon l'invention**

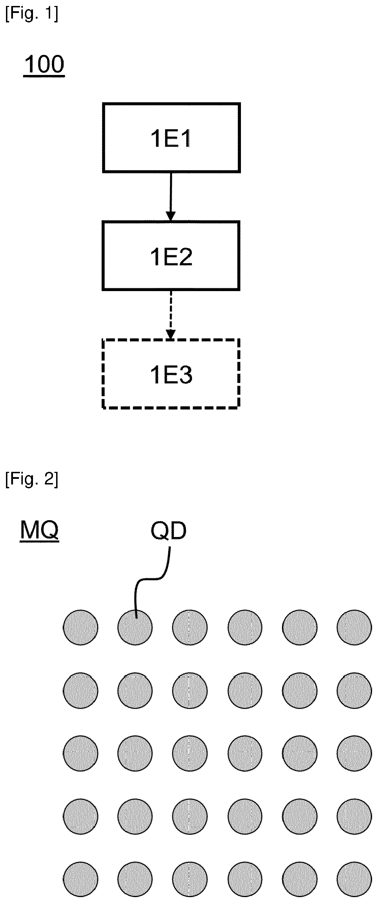

Pour cela, un premier aspect de l'invention illustré à la [Fig. 1] concerne un procédé 100 de manipulation d'au moins une particule chargée PC contenue dans un groupe GC de boites quantiques QD d'une matrice MQ de boites quantiques QD, dit groupe cible GC. De préférence, le procédé 100 de manipulation concerne une pluralité de groupes cibles GC comprenant chacun une ou plusieurs boites quantiques QD et contenant chacun une ou plusieurs particules chargées PC, la manipulation étant effectuée sur les particules chargées PC de chacun de ces groupes cibles GC. Dans la suite, l'expression manipulation d'un groupe cible GC devra donc être comprise comme la manipulation des particules chargées PC contenues dans ledit groupe cible GC.

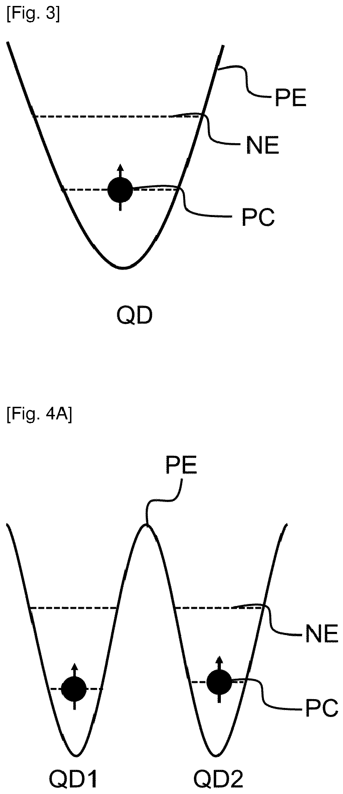

La [Fig. 2] illustre de manière schématique une matrice MQ de boites quantiques QD employée dans la mise en œuvre d'un procédé 100 selon l'invention. Chaque cercle grisé illustre une boite quantique QD de la matrice MQ qui peut, par le biais de grilles (non représentées), être contrôlée de sorte à pouvoir se coupler ou au contraire s'isoler des boites quantiques QD adjacentes. Comme on le verra dans la suite, le couplage entre deux boites quantiques QD est notamment utile pour former et manipuler les groupes cibles GC évoqués précédemment. Une telle matrice MQ de boites quantiques QD est par exemple illustrée aux figures 1 et 3 du document FR 306629 A1.

Comme illustré à la [Fig. 3], chaque boite quantique QD de la matrice MQ de boites quantiques QD contient une ou plusieurs particules chargées PC, porteuses d'une charge et d'un spin, et confinées par une barrière de potentiel PE. Par exemple, la particule chargée PC peut être un électron ou bien encore un trou. Dans ce potentiel PE, la particule chargée PC peut adopter plusieurs états NE (représentés en pointillé), chaque état étant associé à un spin, l'écart en énergie entre ces états NE étant fonction du potentiel électrostatique PE et, éventuellement, du champ magnétique. Le potentiel électrostatique PE permet également de moduler le régime dans lequel se trouve la boite quantique QD vis-à-vis des autres boites quantiques QD, en particulier de configurer la boite quantique QD ou un groupe cible GC dans un régime totalement isolé que l'on décrira dans la suite.

*Etape 1E1 d'isolement total du ou des groupes cibles*

Le procédé 100 de manipulation selon l'invention comprend au moins une étape 1E1 d'isolement total de chaque groupe cible GC, la barrière de potentiel BPE séparant le groupe cible GC des boites quantiques QD adjacentes étant configurée de sorte que la ou les particules chargées PC contenues dans ledit groupe cible GC considéré ne peuvent pas traverser la barrière BPE de potentiel pour se déplacer vers une boite quantique QD adjacente (et vice-versa) ou bien encore le ou les réservoirs de particule chargée PC (et vice-versa) même lorsqu'une telle transition est autorisée d'un point de vue énergétique.

Contrairement à la configuration partiellement isolée décrite en introduction de cette description, l'utilisation du régime totalement isolée est propre à l'invention. En effet, alors que dans l'état de la technique le régime de blocage de Coulomb (ou régime d'isolation partielle) est utilisé afin de pouvoir manipuler les particules chargées PC contenues dans les boites quantiques QD (par exemple pour mettre en œuvre les opérations quantiques souhaitées), la présente invention démontre qu'il est également possible de manipuler les particules chargées PC en opérant dans un régime au-delà du régime de Coulomb (autrement dit, dans le régime totalement isolé selon l'invention) avec tous les avantages qu'un tel régime procure.

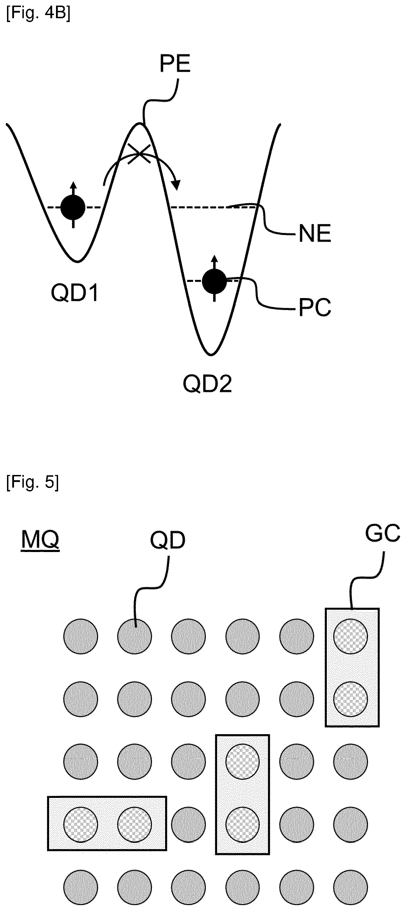

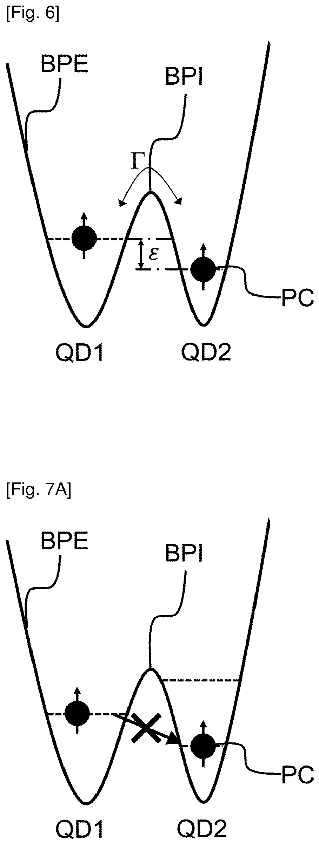

Une illustration schématique de la notion de régime totalement isolé pour deux boites quantiques est proposée à la [Fig. 4A] et la [Fig. 4B]. Cette notion peut être facilement étendue à un groupe cible GC comprenant deux boites quantiques QD ou plus comme cela sera détaillée dans la suite où la barrière de potentielle assurant l'isolement total du groupe cible GC est la barrière de potentielle extérieure BPE dudit groupe cible GC (cf. [Fig. 6]).

La [Fig. 4A] illustre une première boite quantique QD1 séparée d'une deuxième boite quantique QD2 par une barrière de potentiel PE. Dans la situation de la figure 4A, le transfert d'une particule chargée PC de la première boite quantique QD1 vers la deuxième boite quantique QD2 (et vice-versa) n'est pas autorisé énergétiquement, les niveaux d'énergie NE disponibles dans chacune des boites quantiques QD (c'est-à-dire non occupés par une particule chargée PC) étant au-dessus de l'énergie de chaque particule chargée PC.

La [Fig. 4B] illustre une situation dans laquelle le potentiel électrostatique au sein de la première boite quantique QD1 a été modifié, par exemple durant la manipulation de la particule chargée PC contenue ladite boite quantique QD1, et la particule chargée PC contenue dans cette première boite quantique QD1 a une énergie égale à l'énergie du niveau d'énergie NE libre de la deuxième boite quantique QD2. Du point de vue énergétique, un transfert de la particule chargée PC de la première boite quantique QD1 vers la deuxième boite quantique QD2 est donc possible. En revanche, dans le régime totalement isolé selon l'invention, la hauteur et la largeur de la barrière de potentielles PE (caractérisée par le paramètre Γ connu du domaine sous le nom de *tunneling rate)* sont suffisamment élevées pour qu'un tel transfert n'ait pas lieu sur le temps caractéristique (ou la durée caractéristique) de manipulation des particules chargées PC contenues dans les boites quantiques QD ou de la mesure de l'état de charge d'une boite quantique QD, noté $\tau_{manip}$ dans la suite. Dans l'exemple de la [Fig. 4B], la particule chargée PC reste donc dans la première boite quantique QD1 et l'état de charge de cette dernière est donc inchangé durant le temps $\tau_{manip}$ que dure la manipulation ou la lecture de l'état de charge.

Autrement dit, considérer que deux boites quantiques QD1,QD2 sont dans un régime totalement isolé l'une par rapport à l'autre (mais également vis-à-vis des boites quantiques QD adjacentes) durant une manipulation ou la lecture de l'état de charge revient à dire que, durant la durée $\tau_{manip}$ de cette manipulation ou de cette lecture, le passage par effet tunnel d'une particule chargée PC d'une boite quantique QD1 à une autre boite quantique QD2 (ou tunneling en anglais) a une probabilité très faible (par exemple 1/100, voire 1/1000, voire 1/10000, voire même 1/100000) de se produire. Aussi, la condition précédente peut être formulée à l'aide de la relation suivante :

[Formule 1]

$$\Gamma \ll \frac{1}{\tau_{manip}}$$

Par exemple, Γ est cent (100), voire mille (1000) fois, voire dix milles (10000) fois inférieure à $\frac{1}{\tau_{manip}}$ . Ainsi, sur la durée $\tau_{manip}$ caractéristique de la manipulation ou de la lecture de l'état de charge, une particule chargée PC ne pourra pas passer d'une boite quantique QD1 dans un régime totalement isolé à une autre boite quantique QD2, même si une telle transition est énergétiquement autorisée.

Le temps caractéristique $\tau_{manip}$ dépend généralement du type de manipulation opérée sur les particules chargées PC contenues dans les boites quantiques QD lors de l'étape 1E2 de manipulation qui sera décrite dans la suite.

Pour donner trois exemples, lorsque l'étape 1E2 de manipulation comprend une ou plusieurs opérations cohérentes des particules chargées PC contenues dans un groupe cible GC, le temps caractéristique $\tau_{manip}$ est fonction du nombre d'opérations associé à la manipulation en question et de la durée de chaque opération, la durée de chaque opération étant elle-même fonction de la fréquence de Rabi pour chaque type de d'opération envisagée.

Lorsqu'il s'agit d'une lecture de la charge (à l'issue d'une conversion spin/charge), alors le temps caractéristique $\tau_{manip}$ est fonction du temps d'acquisition du signal nécessaire pour distinguer les deux états de charge possibles de la boite quantique QD considérée.

Lorsque la manipulation est suivie d'une lecture de l'état de charge, alors les temps caractéristique $\tau_{manip}$ est égale à la somme du temps caractéristique de chaque opération.

Ce temps caractéristique $\tau_{manip}$ peut en outre être modifié au moyen des tensions appliquées aux grilles définissant le potentiel électrostatique PE au niveau de chaque boite quantique QD.

*Etape 1E2 de manipulation d'au moins un groupe GC de boites quantiques QD*

Le procédé 100 de manipulation selon l'invention comprend également, une étape 1E2 de manipulation. Durant cette étape 1E2 de manipulation, le ou les groupes cibles sont maintenus dans le régiment totalement isolé. Autrement dit, les boites quantiques QD d'un même groupe GC cible ne sont pas totalement isolées entre elles, mais sont dans un régime totalement isolé relativement aux boites quantiques QD extérieures au groupe GC cible considéré, et en particulier des boites quantiques QD qui leur sont adjacentes.

De préférence, une pluralité de groupes GC cibles est considérée lors de cette étape 1E2 de manipulation. Dans ce cas, les opérations effectuées sur chaque groupe cible GC durant l'étape 1E2 de manipulation sont généralement différentes. Par exemple, si l'étape 1E2 de manipulation concerne un premier groupe cible GC et un deuxième groupe cible GC, alors les opérations effectuées sur le premier groupe cible GC pourront être différentes de la ou des opérations effectuées sur le deuxième groupe cible GC.

Il est intéressant de noter que, lors de cette étape 1E2 de manipulation, plusieurs groupes cibles GC peuvent être manipulés en parallèle. Le régime totalement isolé adopté par les différents groupes cibles GC permet de garantir qu'aucune particule chargée PC n'est échangée entre les différents groupes cibles GC ou entre les groupes cibles GC et les boites quantiques QD voisines desdits groupes cibles GC.

Bien entendu, l'étape 1E2 de manipulation peut comprendre une pluralité d'opérations qui se succèdent dans le temps. La nature de ces opérations va être examinée dans la suite. Avant cela, la notion de groupe cible GC va maintenant être détaillée.

*Illustration d'un ou plusieurs groupes cibles GC*

Afin d'illustrer la notion de groupes cibles GC selon l'invention, les [Fig. 5] et [Fig. 6] vont maintenant être décrites.

La [Fig. 5] illustre une matrice MQ de boites quantiques QD sur laquelle ont été matérialisés par des rectangles trois groupes cibles GC de deux boites quantiques QD, les boites quantiques QD appartenant à un groupe cible GC étant représentées par des cercles à motifs carrés. Dans cet exemple, seuls les particules chargées PC contenues dans les boites quantiques QD relatives à ces trois groupes cibles GC seront manipulées lors de l'étape 1E2 de manipulation.

La [Fig. 6] montre une représentation schématique d'un groupe GC cible comprenant une première particule chargée PC contenue dans une première boite quantique QD1 et une deuxième particules chargée PC contenue dans une deuxième boite quantique QD2. Dans cette configuration à deux boites quantiques QD1 ,QD2, il est possible de distinguer la barrière de potentiel BPI entre les deux boites quantiques QD1,QD2 qui va permettre de moduler le couplage entre ces dernières de la barrière de potentielle extérieure BPE qui assure le régime totalement isolé du groupe cible GC par rapport au reste des boites quantiques QD et notamment des boites quantiques QD adjacentes aux boites quantiques QD1,QD2 constituant le groupe cible GC. Autrement dit, il est possible d'établir un couplage entre deux boites quantiques QD1,QD2 du groupe cible GC en modulant la barrière de potentiel BPI qui les sépare tout en conservant un régime totalement isolé avec le reste des boites quantiques QD.

La configuration d'un groupe cible GC comprenant deux boites quantiques QD1,QD2 peut être caractérisée au moyen de deux paramètres : l'écart entre les niveaux d'énergie NE de chaque particule chargée PC contenue dans chaque boite quantique QD1,QD2, noté $\varepsilon$, et la valeur du paramètre $\Gamma$ associé à la barrière de potentiel BPI qui sépare les deux boites quantiques QD1,QD2 (et donc les deux particules PC chargées contenues dans les deux boites quantiques QD1 ,QD2). Il est possible de modifier l'un et l'autre par l'application de tensions sur des grilles de contrôle de sorte à obtenir la configuration la plus adaptée à la manipulation souhaitée. Le paramétrage de ces deux propriétés en vue d'une manipulation quantique est une technique bien connue de la personne du domaine. Un tel paramétrage est par exemple décrit dans les documents cités en introduction et ne sera donc pas répété ici par soucis de concision.

Dans l'exemple qui vient d'être détaillé, le groupe cible GC considéré comprend deux boites quantiques QD1,QD2. Cependant, un groupe cible GC peut également ne comprendre qu'une seule boite quantique QD (auquel cas cette dernière est en isolement total vis-à-vis de toutes les autres boites quantiques QD de la matrice MQ lors de l'étape 1E2 de manipulation) ou bien encore trois boites quantiques QD ou plus. De manière générale, le nombre de boites quantiques QD dans chaque groupe cible GC est fonction du type de manipulation quantique que l'on souhaite appliquer, et ce nombre peut être différent pour différents groupes cibles GC lors d'une même étape 1E2 de manipulation.

*Opération cohérente*

L'étape 1E2 de manipulation peut par exemple comprendre une ou plusieurs opérations cohérentes des particules chargées PC contenues dans chaque groupe cible GC. Ces opérations peuvent par exemple être mise en œuvre à l'aide de micro-ondes appliquées sur chaque groupe cible GC. Deux exemples bien connus de méthodes par micro-ondes sont les méthodes ESR (de l'anglais Electron Spin Resonance) et/ou EDSR (de l'anglais Electric Dipole Spin Resonance), et/ou des pulses d'échange. D'autres techniques peuvent bien entendu être employées.

*Opération de contrôle électrostatique*

L'étape 1E2 de manipulation peut également comprendre une ou plusieurs opérations de contrôle électrostatique appliquées à un ou plusieurs groupes cibles GC, par exemple pour contrôler l'effet Stark ou la contre-réaction ESR (ou feedback ESR en anglais). Ce type d'opération est bien connu de la personne du domaine et ces dernières ne seront donc pas détaillées davantage ici.

*Opération de conversion spin/charge*

L'étape de manipulation peut également comprendre une opération de conversion spin/charge réalisée sur un groupe cible GC constitué d'un premier sous-groupe de boites quantiques QD1 et d'un deuxième sous-groupe de boites quantiques QD2. Dans ce cas de figure, l'étape de manipulation est ensuite suivie d'une étape 1E3 de lecture de l'état de charge qui sera décrite dans la suite.

Durant l'opération de conversation spin/charge, l'état de spin de la particule chargée PC ou des particules chargées PC contenue dans le premier sous-groupe de boites quantiques QD1 est converti, à l'aide du deuxième sous-groupe de boites quantiques QD2 en un état de charge.

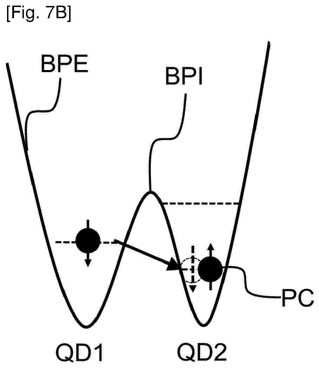

L'opération de conversion spin/charge est une technique bien connue de la personne du domaine et cette dernière ne sera donc pas détaillée ici, le principe général d'une telle conversion étant cependant évoqué. Plus particulièrement, ce principe général est illustré à la [Fig. 7A] et à la [Fig. 7B] à l'aide d'un groupe cible comprenant une première boite quantique QD1 constituant le premier sous-groupe et une deuxième boite quantique QD2 constituant le deuxième sous-groupe.

Sur ces deux figures, la deuxième boite quantique QD2 a un état d'énergie inoccupé, ce dernier correspondant à un état de spin down (spin bas aussi noté d).

Dans la configuration de la [Fig. 7A], l'état de spin de la particule chargée PC contenue dans la première boite quantique QD1 est un état de spin up (spin haut aussi noté u), et la particule chargée PC de ladite boite quantique QD1 ne peut donc pas passer de la première boite quantique QD1 vers la deuxième boite quantiques QD2. Dans cette configuration, l'état du système reste dans la configuration (1,1). Autrement dit, l'état de charge de la deuxième boite quantique QD2 n'est pas modifié.

Dans la configuration de la [Fig. 7B], l'état de spin de la particule chargée PC contenue dans la première boite quantique QD1 est l'état de spin down, et la particule chargée PC de ladite boite quantique QD1 peut donc passer de la première boite quantique QD1 vers la deuxième boite quantique QD2. Dans cette configuration, l'état du système passe de la configuration (1,1) à la configuration (0,2). Autrement dit, l'état de charge de la deuxième boite quantique QD2 est modifié.

On comprend de cet exemple que l'état de spin de la particule chargée PC contenue dans la première boite quantique QD1 est converti en un état de charge de la deuxième boite quantique QD2. Dans le présent exemple, un état de charge (1,1) correspond à un état de spin up tandis qu'un état de charge (0,2) correspond à un état de spin down, c'est-à-dire qu'une modification de l'état de charge de la deuxième boite quantique QD2 correspond à un état spin down de la particule chargée PC contenue dans la première boite quantique QD1 et l'absence de modification de l'état de charge de la deuxième boite quantique QD2 correspond à un état spin up de la particule chargée contenue dans la première boite quantique QD1.

Aussi, afin de déterminer l'état de spin de la première boite quantique QD1, il est nécessaire de mesurer l'état de charge de la deuxième boite quantique QD2.

### Etape de lecture de l'état de charge

Pour cela, le procédé 100 selon un premier aspect de l'invention comprend, pour chaque deuxième groupe de boites quantiques d'un groupe cible GC dont l'état de charge est représentatif d'un état de spin (dans l'exemple précédent, l'état de charge de la deuxième boite quantique QD2 est représentatif d'un état de spin, en l'occurrence l'état de spin de la particule chargée PC contenue dans la première boite quantique QD1), une étape 1E3 de lecture de l'état de charge dudit sous-groupe de boites quantiques QD2, le premier sous-groupe et le deuxième sous-groupe de boites quantique QD étant de préférence en régime totalement isolé lors de cette étape 1E3, l'état de charge du deuxième sous-groupe de boites quantiques considérée permettant de déterminer l'état de spin de la ou des particules chargées PC contenues dans le premier sous-groupe dont ledit état a été converti lors de l'opération de conversion spin/charge précédente.

Comme mentionné dans le paragraphe précédent, de préférence, l'étape 1E3 de détermination de l'état de charge est précédée d'une étape d'isolement total du premier sous-groupe et du deuxième sous-groupe de boites quantiques de sorte que l'étape 1E3 de détermination de l'état de charge se fait alors que le premier sous-groupe et le deuxième sous-groupe de boites quantiques QD de la matrice MQ sont dans un régime totalement isolé. Autrement dit, l'état de charge du premier sous-groupe et du deuxième sous-groupe de boite quantique QD est figé et la lecture de l'état de charge du deuxième sous-groupe de boites quantiques QD impliqué dans l'opération de conversion spin/charge peut se faire avec la quasi-certitude que l'état de charge dudit sous-groupe est celui qui correspond à l'état de charge dudit sous-groupe à l'issue de l'opération de conversion. De plus, le régime totalement isolé a pour conséquence d'augmenter la distance séparant les particules chargées PC du premier sous-groupe et du deuxième sous-groupe, ce qui a pour avantage d'augmenter le signal relatif à la mesure de l'état de charge d'un sous-groupe donné.

### Avantage du régime totalement isolé

La description qui vient d'être faite des étapes 1E1, 1E2, 1E3 permet de mieux comprendre l'intérêt du régime totalement isolé selon l'invention.

En particulier, durant l'étape 1E2 de manipulation, les boites quantiques QD non manipulées sont de préférence dans le régime totalement isolé ce qui garantit que leur état de charge reste figé et ne sera pas modifié par les étapes de manipulation des groupes cibles GC. Par ailleurs, bien que couplées entre elles, les boites quantiques QD d'un même groupe cible GC sont dans un régime totalement isolé relativement aux autres boites quantiques QD ce qui permet d'assurer la conservation de la charge au niveau de chaque groupe cible GC lors de l'étape 1E2 de manipulation.

De plus, durant l'étape 1E3 de détermination de l'état de charge, chaque sous-groupe de boite quantique QD de la matrice MQ de boites quantiques QD est dans un régiment totalement isolé, ce qui permet de s'assurer que l'état de charge du sous-groupe QD2 impliqué dans l'opération de conversion déterminé lors de cette étape 1E3 est identique à l'état de charge dudit sous-groupe QD2 à l'issue de l'opération de conversion spin/charge.

A la lecture des éléments qui précèdent et en particulier de la définition qui a été donnée du régime totalement isolé, la personne du métier pourra trouver, avec très peu d'effort, le régime totalement isolé correspondant à un système donné. Néanmoins, à des fins d'illustration, un procédé 200 de détermination des paramètres correspondant au régime totalement isolé dans une matrice MQ de boites quantiques QD va maintenant être décrit.

## Procédé de détermination de la position du régime totalement isolé d'une boite quantique

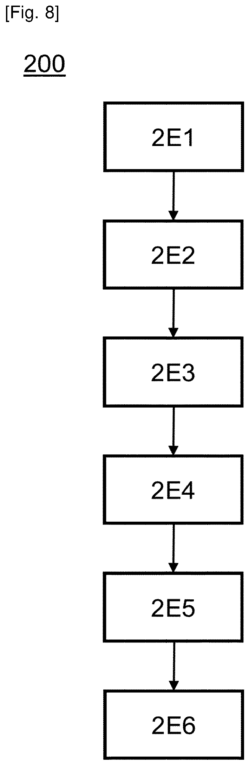

Pour cela, un deuxième aspect de l'invention illustré à la [Fig. 8] concerne un procédé 200 de détermination de la position du régime totalement isolé entre une première boite quantique QD1 et une deuxième boite quantique QD2.

Comme précédemment décrit, un système comprenant deux boites quantiques QD1,QD2 peut être caractérisé par un premier paramètre $\Gamma$ relatif à la barrière de potentiel séparant les deux boites quantiques QD1,QD2 du système et par un deuxième paramètre $\varepsilon$ relatif à la différence en énergie entre l'état fondamental de la première boite quantique QD1 et l'état fondamental de la deuxième boite quantique QD2, le premier et le deuxième paramètre pouvant être modifiés à l'aide d'au moins deux tension appliquées sur des grilles. Par ailleurs, le système peut prendre soit l'état de charge (1,1), soit l'état de charge (0,2) soit encore l'état de charge (2,0) où l'état de charge $(n_{QD1},n_{QD2})$ correspond à un état de charge $n_{QD1}$ pour la première boite quantique QD1 et un état de charge $n_{QD2}$ pour la deuxième boite quantique QD2.

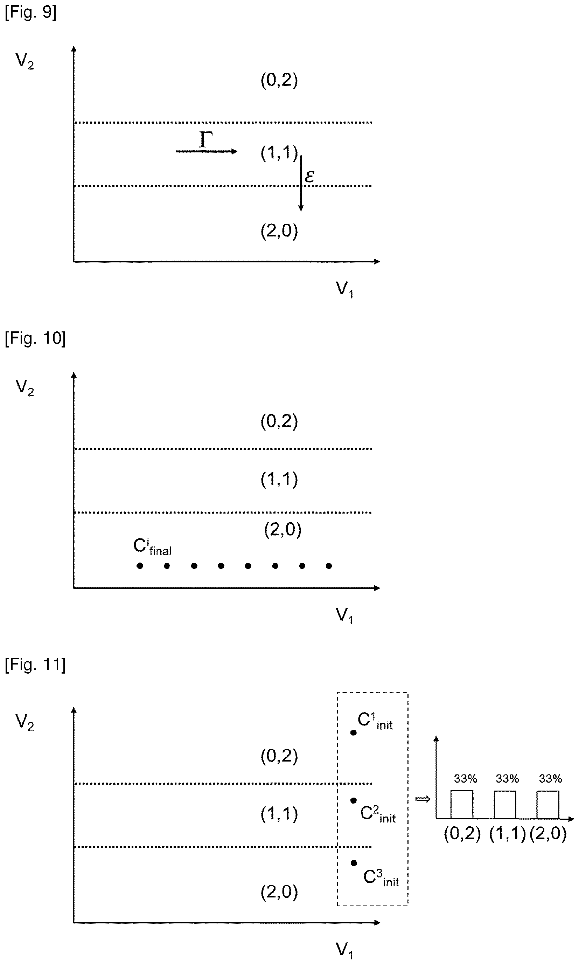

Il est possible de représenter la valeur de ces deux paramètres dans un diagramme de stabilité tel qu'illustré à la [Fig. 9]. Dans cet exemple, la paramètre $\Gamma$ peut être modulé à l'aide d'une première tension V1, la modification correspondant à un déplacement du système selon l'axe des abscisses dans le diagramme de stabilité. De la même manière, le paramètre $\varepsilon$ peut être modulé à l'aide d'une deuxième tension V2, la modification de ce paramètre correspondant à un déplacement selon l'axe des ordonnées dans le diagramme de stabilité. Ainsi, dans cette représentation, deux points ayant la même abscisse correspondent à deux configurations ayant une barrière de potentiel $\Gamma$ identique entre les deux boites quantiques QD considérées, tandis que deux points ayant la même ordonnée correspondent à deux configurations ayant une valeur de $\varepsilon$ identique. Par ailleurs, l'état de charge associé à l'état fondamental de chaque configuration a été représenté sur le diagramme de stabilité.

Afin de balayer l'ensemble du diagramme de stabilité et identifier sur ce dernier les valeurs de $\Gamma$ correspondant à un régime isolé, une pluralité de configurations finales $C^i_{final}$ est choisie, chaque configuration finale $C^i_{final}$ correspondant à une valeur différente du premier paramètre $\Gamma$ des autres configurations finales $C^i_{final}$ de la pluralité de configurations finales $C^i_{final}$ de sorte à couvrir l'ensemble des valeurs du premier paramètre $\Gamma$ que peut prendre le système ou, tout du moins, que l'on souhaite caractériser. Par ailleurs, l'état de charge de l'état fondamental est connu pour chaque configuration finale.

Une telle pluralité de configurations finales $C^i_{final}$ est illustrée à la [Fig. 10] (huit configurations finales $C^i_{final}$ dans cet exemple). Dans l'exemple donné, toutes les configurations finales $C^i_{final}$ sont associées à un même état de charge (2,0). Cependant, une configuration finale peut être associée à n'importe lequel des trois états de charge que peut prendre le système.

En outre, pour chaque configuration finale $C^i_{final}$ de la pluralité de configurations finales $C^i_{final}$, une pluralité de configurations initiales $C^i_{init}$ va être considérée. Cette pluralité de configurations initiales $C^i_{init}$ correspond à une distribution d'état de charge connue. Par exemple, si la pluralité de configurations initiales comprend douze configurations, il sera possible de choisir une distribution de charge dans laquelle quatre configurations initiales $C^i_{init}$ correspondent à un état de charge (2,0), quatre configurations initiales $C^i_{init}$ correspondent à un état de charge (1,1) et quatre configurations initiales $C^i_{init}$ correspondent à un état de charge (0,2). Un exemple de trois configurations initiales $C^i_{init}$ est donné à la [Fig. 11] dans lequel chaque configuration initiale correspond à un état de charge donné différent des deux autres configurations initiales. Il est possible d'associer à ces trois configurations initiales une distribution des états de charge initiale comme illustré sur la [Fig. 11] dans laquelle, par exemple, chaque état de charge est associé avec une probabilité de 33%. Pour chacune des configurations initiales $C^i_{init}$, le procédé 200 comprend les étapes qui vont être décrite maintenant.

Le procédé comprend tout d'abord une étape 2E1 d'initialisation du système dans une première configuration correspondant à la configuration initiale considérée. A l'issue de cette étape 2E1 d'initialisation, le système est dans l'état de charge fondamental associé à la configuration initiale. Par exemple, sur la [Fig. 11], l'état de charge du système lors de l'étape d'initialisation est (0,2) pour la première configuration initiale $C^1_{init}$, (1,1) pour la deuxième configuration initiale $C^1_{init}$ et (2,0) pour la troisième configuration initiale $C^1_{init}$.

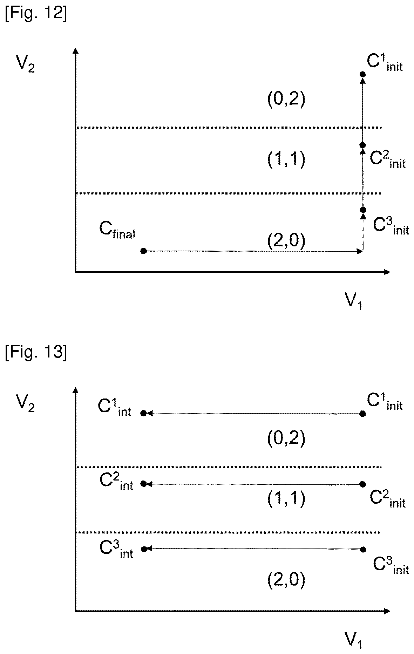

Dans un mode de réalisation illustré à la [Fig. 12] pour trois configurations initiale $C^i_{init}$, l'étape 2E1 d'initialisation est mise en œuvre à partir de la configuration finale $C_{final}$ considérée et comprend :

-    une première sous-étape d'augmentation du premier paramètre Γ jusqu'à la valeur relative à la configuration initiale souhaitée, la valeur du deuxième paramètre $\varepsilon$ n'étant pas modifiée lors de cette première sous-étape ;

- Une deuxième sous-étape de variation du deuxième paramètre $\varepsilon$ jusqu'à la valeur relative à la configuration initiale souhaitée, la valeur du première paramètre Γ n'étant pas modifiée lors de cette deuxième sous-étape.

Comme illustré à la [Fig. 13], le procédé comprend ensuite une étape 2E2 de diminution du premier paramètre Γ (c'est-à-dire une augmentation de la barrière tunnel séparant la première boite quantique QD1 de la deuxième boite quantique QD2), le système étant dans une deuxième configuration, dite configuration intermédiaire $C^i_{int}$, à l'issue de cette étape 2E2, la valeur du premier paramètre Γ de la configuration intermédiaire étant égale à la valeur du premier paramètre Γ de la configuration finale considérée.

Il est utile de noter que seule la valeur du première paramètre Γ est modifiée et que donc la valeur du deuxième paramètre $\varepsilon$ de la configuration intermédiaire $C^i_{int}$ est égale à la valeur du deuxième paramètre $\varepsilon$ de la configuration initiale $C^i_{init}$. Aussi, l'état de charge fondamental associé à la configuration intermédiaire $C^i_{int}$ est identique à l'état de charge fondamental associé à la configuration initiale $C^i_{init}$. Autrement dit, l'état de charge du système n'est pas modifié lors de cette étape 2E2. Par exemple, sur la [Fig. 13], l'état de charge du système à l'issue de l'étape de diminution du premier paramètre Γ est (0,2) pour la première configuration intermédiaire $C^1_{int}$, (1,1) pour la deuxième configuration intermédiaire $C^2_{int}$ et (2,0) pour la troisième configuration intermédiaire $C^3_{int}$.

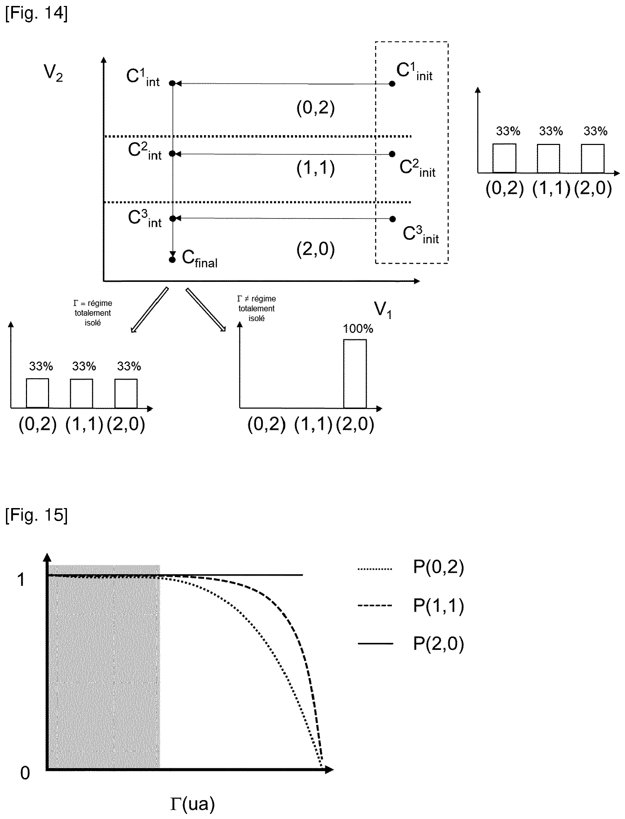

Comme illustré à la [Fig. 14], le procédé comprend également une étape 2E3 de variation du deuxième paramètre $\varepsilon$, la valeur du premier paramètre Γ étant conservée lors de cette étape, le système étant dans une troisième configuration, correspondant à la configuration finale $C_{final}$ considérée à l'issue de cette étape 2E3. Il est utile de noter que, lors de cette étape 2E3, la valeur du premier paramètre Γ n'est pas modifiée et que donc la barrière de potentiel séparant les deux boites quantiques QD1,QD2 n'est pas modifiée. En revanche, la valeur du paramètre $\varepsilon$ étant modifié, l'état de charge fondamental associé à la configuration finale $C_{final}$ peut être différent de l'état de charge fondamental associé à la configuration initiale $C^i_{init}$ (et dans lequel se trouve le système à l'issue de l'étape d'initialisation 2E1).

Il est possible d'examiner deux cas de figure : le premier cas où la valeur du premier paramètre Γ lors de cette étape correspond au régime totalement isolé et le deuxième cas où la valeur du premier paramètre Γ lors de cette étape ne correspond pas au régime totalement isolé. Ces deux cas de figure sont schématisés à la [Fig. 14].

Dans le premier cas, aucun transfert de charge n'est possible entre la première boite quantique QD1 et la deuxième boite quantique QD2. Aussi, même si la configuration finale $C_{final}$ est associée à un état de charge fondamental différent de l'état de charge fondamental associée à la configuration initiale $C^i_{init}$, cet état de charge n'est pas modifié lors de l'étape de variation du deuxième paramètre $\varepsilon$. Par exemple, sur la [Fig. 14], l'état de charge du système à l'issue de l'étape de variation du deuxième paramètre $\varepsilon$ est (0,2) pour le système initialement (c'est-à-dire au début de l'étape 2E3 de variation du deuxième paramètre $\varepsilon$) dans la première configuration intermédiaire $C^1_{int}$, (1,1) pour le système initialement dans la deuxième configuration intermédiaire $C^2_{int}$ et (2,0) pour le système initialement dans la troisième configuration intermédiaire $C^3_{int}$. Il ressort de ce qui précède que, dans ce premier cas, la distribution des états de charge initiale sera conservée. Autrement dit la probabilité associée un état de charge à l'état initial est égal à la probabilité associé audit état de charge à l'état final.

Dans le deuxième cas, un transfert de charge est possible entre la première boite quantique QD1 et la deuxième boite quantique QD2. Aussi, si la configuration finale $C_{final}$ est associée un état de charge fondamental différent de l'état de charge fondamental associé à la configuration initiale $C^i_{init}$, ce dernier est modifié lors de l'étape de variation du deuxième paramètre $\varepsilon$. Par exemple, sur la [Fig. 14], l'état de charge du système à l'issue de l'étape de variation du deuxième paramètre $\varepsilon$ est (2,0) quelle que soit la configuration intermédiaire $C^i_{int}$ (et donc la configuration initiale) considérée. Il ressort de ce qui précède que, dans ce deuxième cas, la distribution des états de charge initiale ne sera pas conservée. Autrement dit la probabilité associée un état de charge à l'état initial est différent de la probabilité associé audit état de charge à l'état final.

Afin de pouvoir établir l'état de charge du système dans sa configuration finale $C_{final}$, le procédé comprend en outre étape 2E4 de détermination de l'état de charge du système dans la configuration finale $C_{final}$.

Comme mentionné précédemment, ces étapes 2E1-2E4 sont réalisées pour une pluralité de configuration initiales $C^i_{init}$. Il est donc possible de constituer une statistique des états de charge mesurés dans la configuration finale $C_{final}$ de sorte à déterminer une distribution des états de charge mesurés dans la configuration finale $C_{final}$ (et donc la probabilité associée à chaque état de charge dans la configuration finale). Pour cela le procédé comprend une étape 2E5 de détermination de la distribution des états de charge mesurés dans la configuration finale $C_{final}$.

Comme déjà détaillé, si la valeur du premier paramètre Γ correspond à un régime totalement isolé, alors la distribution des états de charges mesurés dans la configuration finale $C_{final}$ sera sensiblement identique à la distribution des états de charge initiale. Aussi, le procédé comprend une étape 2E6 de comparaison de la distribution des états de charge initiale à la distribution des états de charges mesurés dans la configuration finale $C_{final}$, la valeur du premier paramètre $\Gamma$ de la configuration finale $C_{final}$ correspondant à un régime totalement isolé si les deux distributions sont sensiblement identiques. Dans un mode de réalisation, la distribution initiale et la distribution finale sont identiques si, pour chaque état de charge, la probabilité associée à cet état de charge pour la configuration initiale est identique à la probabilité associée à cet état de charge pour la configuration finale. Dans un mode de réalisation, la probabilité initiale est identique à la probabilité finale lorsque la différence en valeur absolue entre les deux probabilités est inférieure ou égale à 10% de la valeur initiale, voire inférieure 1% de la valeur initiale, voire encore inférieure ou égale à 0.1% de la valeur initiale.

Par ailleurs, ces différentes étapes 2E1-2E6 étant répétées pour une pluralité de configurations finales $C^i_{final}$ et donc pour une pluralité de valeurs du premier paramètre $\Gamma$, il possible d'identifier la position du régime totalement isolée.

A partir des statistiques ainsi obtenues, il est ensuite possible de déterminer, pour une configuration finale donnée et donc un état de charge donnée, par exemple (2,0), la probabilité que l'état de charge associé à la configuration initiale soit conservé (c'est-à-dire mesuré 2E4 de détermination de l'état de charge du système dans la configuration finale $C_{final}$) en fonction de la valeur du premier paramètre $\Gamma$. Une telle probabilité est illustrée à la [Fig. 15] pour les trois états de charge initiaux différents. A partir de cette courbe, il est ensuite possible de déterminer les valeurs du premier paramètre $\Gamma$ correspondant à un régiment totalement isolé et illustrées par la zone grisée de la [Fig. 15].

Dans un mode de réalisation, après l'étape 2E3 d'augmentation du deuxième paramètre $\varepsilon$ et avant étape 2E4 de détermination de l'état de charge du système dans la configuration finale $C_{final}$, le procédé comprend une étape d'attente pendant une durée prédéterminée. Le procédé 200 selon l'invention peut alors être répétée pour différents temps d'attente. Cela revient à caractériser différents temps caractéristiques et donc à identifier le régime d'isolement total en fonction du temps caractéristique.

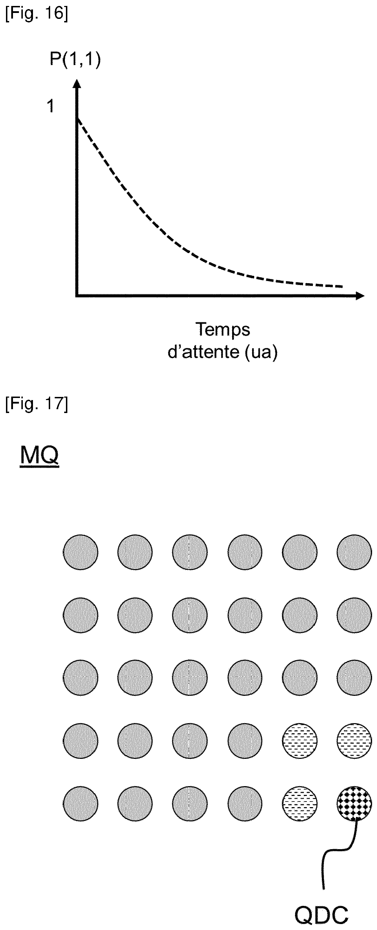

Par exemple, en considérant une configuration initiale associée à l'état de charge (1,1) et une configuration finale associé à l'état de charge (0,2) ou (2,0), il est possible de déterminer la probabilité que l'état de charge déterminé pour la configuration finale soit égal à l'état de charge (1,1) en fonction du temps d'attente. Une telle probabilité est représentée à la [Fig. 16]. Une telle courbe permet notamment de déterminer la valeur du premier paramètre $\Gamma$.

A l'issue du procédé 200 selon un deuxième aspect de l'invention, il est donc possible d'identifier, dans le diagramme de stabilité du système, la position du régime totalement isolé d'une première boite quantique QD1 relativement à une deuxième boite quantique QD2.

**Exemple de mise en œuvre des procédés selon un premier ou deuxième aspect de l'invention**

Les procédés 100, 200 selon un premier et deuxième aspect de l'invention vont maintenant être illustrés au travers d'un exemple mettant en jeu une matrice MQ de boites quantiques QD.

*Identification du régime totalement isolé pour chaque qubit de la matrice*

Dans un premier temps, il convient de déterminer le régime totalement isolé associé à chaque boite quantique QD de la matrice MQ. Afin d'illustrer cette identification, cette dernière va être mise en œuvre pour la boite quantique cible QDC repéré par des motifs losange sur la [Fig. 17]. Cette boite quantique cible QDC est entourée de trois autres boites quantiques QD repérées par des motifs en tiret. La boite quantique cible QDC est donc dans un régime totalement isolé par rapport aux trois autres boites quantiques QD, lorsqu'elle est totalement isolée de chacune des trois boites quantiques QD qui l'entourent. Comme cela a été détaillé auparavant, le procédé 200 selon un deuxième aspect de l'invention permet de déterminer le régime totalement isolé entre une première boite quantique QD1 et une deuxième boite quantique QD2 formant un système de deux boites quantiques. Il s'agit donc ici de mettre en œuvre ce procédé avec chacun des trois systèmes que la boite quantique cible QDC peut former avec chacune des boites quantiques QD qui l'entourent. Une fois que le procédé 200 de détermination de la position du régime totalement isolé a été mis en œuvre pour les trois systèmes ainsi identifiés, les paramètres permettant de configurer la boite quantique cible QDC dans un régime totalement isolé par rapport aux boites quantiques QD qui l'entourent sont connus.

Une procédure identique est répétée pour chacune des boites quantiques QD de la matrice MQ. Il est alors possible d'établir un régime isolé pour une ou plusieurs boites quantiques QD ou pour un ou plusieurs groupes GC de boites quantiques QD.

*Etape de manipulation comprenant une opération de conversion spin/charge suivie d'une étape de détermination de l'état de charge*

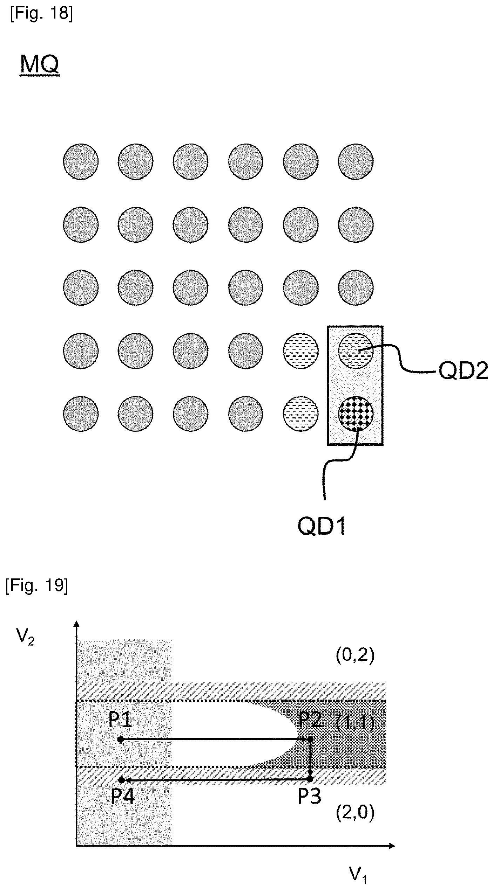

Dans cet exemple illustré à la [Fig. 18], une étape 1E2 de manipulation comprenant une opération de conversion spin/charge mise en œuvre sur un groupe cible GC comprenant deux boites quantiques QD1,QD2 va être décrite tout comme l'étape 1E3 de détermination de l'état de charge de la boite quantiques impliquée dans la conversion.

Les différentes étapes mise en œuvre seront en outre illustrées à l'aide d'un diagramme de stabilité présenté à la [Fig. 19] et relatif au groupe cible comprenant une première boite quantique QD1 et une deuxième boite quantique QD2, l'opération de conversion spin/charge visant à convertir l'état de spin de la particule chargée PC contenue dans la première boite quantique QD1 en état de charge de la deuxième boite quantique QD2. Pour rappel, la position du régime totalement isolé de la première boite quantique QD1 par rapport à la deuxième boite quantique QD2 dans ce diagramme est connue car elle a été obtenue précédemment par la mise en œuvre d'un procédé 200 selon un deuxième aspect de l'invention. Elle est illustrée par la zone grisée sur le diagramme de stabilité de la [Fig. 19]. Il est bien entendu que cette zone grisée correspond au régime totalement isolé en prenant en compte le temps caractéristique relatif à l'étape de manipulation comprenant une opération de conversion spin/charge et l'étape de détermination de l'état de charge.

De préférence, le procédé 100 de manipulation comprend tout d'abord une étape d'isolement total de chaque boite quantique QD de la matrice MQ, la barrière de potentiel PE de chaque boite quantique QD étant configurée de sorte que la particule chargée PC relative à ladite boite quantique ne peut pas traverser la barrière de potentiel PE pour se déplacer vers une boite quantique QD adjacente même lorsqu'une telle transition est autorisée d'un point de vue énergétique. Dans le diagramme de stabilité de la [Fig. 19], le système est à la position P1 correspondant au régime totalement isolé. Dans cette région, l'état de spin des particules chargées contenues dans la première boite quantique QD1 et la deuxième boite quantique QD2 peut être décrit par les vecteurs propres (u,u), (d,d), (d,u) et (d,d) où d signifie down (bas), u signifie up (haut), la première valeur du couple étant relative à l'état de spin de la particule chargée PC contenue dans la première boite quantique QD1 et la deuxième valeur du coupe étant relative à l'état de spin de la particule chargée PC contenue dans la deuxième boite quantique QD2.

Le procédé comprend également une étape 1E1 d'isolement total du groupe cible GC constitué par la première boite quantique QD1 et la deuxième boite quantique QD2 relativement aux autres boites quantiques QD de la matrice MQ, la barrière de potentiel BPE séparant le groupe cible GC des boites quantiques QD adjacente audit groupe cible GC étant configurée de sorte que les deux particules chargées PC contenue dans ledit groupe cible GC ne peuvent pas traverser la barrière de potentiel BPE pour se déplacer vers les boites quantiques QD adjacentes au groupe cible GC même lorsqu'une telle transition est autorisée d'un point de vue énergétique. Dans le diagramme de stabilité de la [Fig. 19], le premier système se rend à la position P2 qui correspond à une configuration où le potentiel électrostatique séparant la première boite quantiques QD1 de la deuxième boite quantique QD2 est plus faible permettant le transfert de charge de la première boite quantique QD1 vers la deuxième boite quantique QD2 (c'est en dire en dehors du régime d'isolation totale de la première boite quantique QD1 par rapport à la deuxième boite quantique QD2) nécessaire à la conversion spin/charge. La position P2 se trouve dans une région (matérialisée par la zone à motifs carrés dans la [Fig. 19]) dans laquelle l'état de spin des particules chargées PC contenues dans la première boite quantique QD1 et la deuxième boite quantique QD2 peut être décrit par les vecteurs propres S, T-, T+ et T0 (bien connue de la personne du domaine).

Le procédé comprend ensuite une étape 1E2 de manipulation comprenant une opération de conversion spin/charge durant laquelle l'état de spin de la particule chargée contenue dans la première boite quantique QD1 est converti, à l'aide de la deuxième boite quantique QD2 en un état de charge, la première boite quantique QD1 et la deuxième boite quantique QD2 étant dans un régime totalement isolé relativement aux autres boites quantiques QD lors de cette étape 1E2. Lors de cette étape, le système se déplace dans la position P3 située dans la région de blocage de Pauli (ou blocage de spin - connue de la personne du domaine et matérialisée par la zone rayée dans la [Fig. 19]) de sorte à passer de l'état de charge (1,1) à l'état de charge (0,2), cette transition ne se faisant que pour l'un des deux états de spin de la particule chargée PC contenue dans la première boite quantique QD1. En position P3, la conversion spin/charge a été mise en œuvre et l'état de charge de la deuxième boite quantique QD2 est fonction de l'état de spin de la particule chargée PC initialement contenue dans la première boite quantique QD1. Comme pour la position P2, la position P3 se trouve dans une région dans laquelle l'état de spin des particules chargées contenues dans la première boite quantique QD1 et la deuxième boite quantique QD2 peut être décrit par les vecteurs propres S, T-, T+ et T0.

Afin de lire cet état de charge le procédé 100 comprend une étape 1E3 de détermination de l'état de charge de la deuxième boite quantique QD2, la deuxième boite quantique QD2 étant en dans un régime totalement isolé lors de cette étape 1E3 (y compris relativement à la première boite quantique QD1), l'état de charge de la deuxième boite quantique QD2 permettant de déterminer l'état de spin de la particule chargée initialement contenue dans la première boite quantique QD1. Dans le diagramme de stabilité de la [Fig. 19], le premier système se rend dans la position P4 qui correspond à un régime totalement isolé entre les deux boite quantiques QD1 ,QD2, en restant dans la région de blocage de Pauli lors du transfert. Une fois dans la position P4, les états de charge sont figés et la mesure de l'état de charge de la deuxième boite quantique QD2 peut se faire, par exemple à l'aide d'un électromètre. On notera que la lecture peut se faire en tout point du diagramme de stabilité correspondant à un régime totalement isolé, la condition étant de figer les états de charge après la conversion (c'est-à-dire d'adopter un régime totalement isolé) avant de modifier l'ordonnée de la position adoptée dans le diagramme de stabilité pour la détermination de l'état de charge. Par exemple, la détermination de l'état de charge pourrait se faire en P1 pourvu que la transition de P3 à P1 s'effectue en passant par P4.

*Manipulation d'un groupe de qubits comprenant deux qubits*

Dans cet exemple, l'étape 1E2 de manipulation comprend une opération cohérente mise en œuvre sur un groupe cible GC constitué d'une première boite quantique QD1 et d'une deuxième boite quantique Q2 similaire au système de la [Fig. 15] déjà introduit.

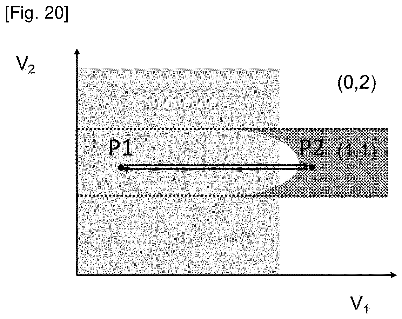

Les différentes étapes seront en outre illustrées à l'aide du diagramme de stabilité illustré à la [Fig. 20]. Pour rappel, la position du régime totalement isolé de la première boite quantique QD1 par rapport à la deuxième boite quantique QD2 dans ce diagramme est connue car elle a été obtenue précédemment par la mise en œuvre d'un procédé 200 selon un deuxième aspect de l'invention. Elle est illustrée par la zone grisée sur le diagramme de stabilité de la [Fig. 20]. Il est bien entendu que cette zone grisée correspond au régime totalement isolé en prenant en compte le temps caractéristique relatif à l'étape de manipulation comprenant une opération cohérente. De manière générale, le temps caractéristique d'une opération cohérente est beaucoup plus court que le temps caractéristique d'une opération de conversion spin/charge suivie d'une étape de détermination de l'état de charge comme dans l'exemple précédent. Aussi la zone grisée du présent exemple est plus étendue que la zone grisée de l'exemple précédente. Il ne s'agit cependant que d'un exemple et certaines opérations cohérentes peuvent être associées à un temps caractéristique plus long que celui de l'exemple précédent.

De préférence, le procédé 100 de manipulation comprend tout d'abord une étape 1E1 d'isolement total en transport de chaque boite quantique QD, la barrière de potentiel PE de chaque boite quantique QD étant configurée de sorte que la particule chargée PC contenue dans ladite boite quantique QD ne peut pas traverser la barrière de potentiel PE pour se déplacer vers une boite quantique adjacente même lorsqu'une telle transition est autorisée d'un point de vue énergétique. Dans le diagramme de stabilité de la [Fig. 20], le système est à la position P1 correspondant au régime totalement isolé à l'issue de cette étape 1E1. Comme déjà mentionné, dans cette région, l'état de spin des particules chargées contenues dans la première boite quantique QD1 et la deuxième boite quantique QD2 peut être décrit par les vecteurs propres (u,u), (d,d), (d,u) et (d,d).

Le procédé comprend également une étape 1E1 d'isolement total du groupe cible GC relativement aux autres boites quantiques QD de la matrice MQ, la barrière de potentiel BPE séparant le groupe cible GC des boites quantiques QD adjacente audit groupe cible GC étant configurée de sorte que les deux particules chargées PC contenue dans ledit groupe cible GC ne peuvent pas traverser la barrière de potentiel BPE pour se déplacer vers les boites quantiques QD adjacentes au groupe cible GC même lorsqu'une telle transition est autorisé d'un point de vue énergétique. Dans le diagramme de stabilité de la [Fig. 20], durant cette étape, le système se rend à la position P2 qui correspond à une configuration où le potentiel électrostatique séparant les deux boites quantiques QD1,QD2 du système est plus faible permettant l'interaction nécessaire à l'étape 1E2 de manipulation. Comme déjà mentionné, la position P2 se trouve dans une région (matérialisée par la zone à motifs carrés dans la [Fig. 20]) dans laquelle l'état de spin des particules chargées PC contenues dans la première boite quantique QD1 et la deuxième boite quantique QD2 peuvent être décrit par les vecteurs propres S, T-, T+ et T0 (bien connue de la personne du domaine).

Le procédé 100 de manipulation comprend ensuite une étape 1E2 de manipulation comprenant une opération cohérente du groupe cible GC de boites quantiques QD1,QD2, étape 1E2 durant laquelle les boites quantiques qubits QD de spin du groupe cible GC sont dans un régime totalement isolé relativement aux autres boites quantiques QD. Aussi, une fois en position P2, une opération cohérente est mise en œuvre sur les deux particules chargées PC contenues dans les boites quantique QD1,QD2 du groupe cible GC.

Une fois l'étape 1E2 de manipulation effectuée, le procédé comprend de préférence une étape d'isolement total de chaque boite quantique QD de la matrice MQ. Dans le diagramme de stabilité de la [Fig. 20], le deuxième système retourne à la position P1 qui correspond à un régime d'isolation totale des qubits QD.

**Dispositif selon l'invention**

Afin de mettre en œuvre un procédé selon l'invention, un troisième aspect de l'invention comprend une matrice MQ de qubits QD et des moyens configurés pour mettre en œuvre un procédé selon un premier aspect ou un deuxième aspect de l'invention. Il comprend notamment des moyens pour appliquer des micro-ondes, par exemple pour mettre en œuvre des méthode ESR (de l'anglais Electron Spin Resonance) et/ou EDSR (de l'anglais Electric Dipole Spin Resonance).

Un tel dispositif susceptible d'être configuré pour mettre en œuvre l'invention est par exemple décrit dans le document FR 306629 A1.

**Revendications**

1.  Procédé (100) de manipulation d'au moins un groupe de boites quantiques (QD) d'une matrice (MQ) de boites quantiques (QD), dit groupe cible (GC), chaque groupe cible (GC) comprenant au moins une boite quantique (QD) et contenant au moins une particule chargée (PC), la matrice (MQ) de boites quantiques (QD) étant configurée pour être connectée à au moins un réservoir de particules chargées (PC), chaque groupe cible (GC) étant défini par une barrière de potentiel (BPE), chaque particule chargée (PC) étant porteuse d'une charge et d'un spin, le procédé comprenant, pour chaque groupe cible (GC) :

- au moins une étape d'isolement (1E1) total du groupe cible (GC) relativement aux autres boites quantiques (QB) de la matrice (MQ), la barrière de potentiel (BPE) séparant le groupe cible (GC) des boites quantiques (QD) de la matrice (MQ) adjacentes audit groupe cible (GC) étant configurée de sorte que la ou les particules chargées (PC) contenues dans le groupe cible (GC) ne peuvent pas traverser la barrière de potentiel (BPE) pour se déplacer vers les boites quantiques (QD) adjacentes au groupe cible (GC) ou au réservoir de particules chargées (PC) même lorsqu'une telle transition est autorisée d'un point de vue énergétique, dit régime totalement isolé ;
- une étape (1E2) de manipulation durant laquelle le groupe cible (GC) est maintenu dans le régime totalement isolé.

2. Procédé (100) selon la revendication précédente dans lequel l'étape de manipulation comprend au moins une opération cohérente.

3. Procédé (100) selon l'une des revendications précédentes dans lequel l'étape de manipulation comprend au moins une opération de contrôle électrostatique.

4. Procédé (100) selon l'une des revendications précédentes dans lequel l'étape (1E2) de manipulation comprend au moins une opération de conversion spin/charge réalisée sur au moins un groupe cible (GC), ledit groupe cible (GC) étant divisé en un premier sous-groupe de boites quantiques (QD1) et un deuxième sous-groupe de boites quantiques (QD2), opération durant laquelle l'état de spin de la ou des particules chargées (PC) contenues dans le premier sous-groupe de boites quantiques (QD1) est converti, à l'aide du deuxième sous-groupe de boites quantiques (QD2) en un état de charge du groupe cible (GC), le procédé comprenant en outre une étape de détermination de l'état de charge du groupe cible (GC) de sorte à déterminer l'état de spin de la ou des particules chargées (PC) contenues dans le premier sous-groupe de boites quantiques (QD1).

5. Procédé (100) selon la revendication précédente dans lequel l'étape de détermination de l'état de charge est précédée d'une étape d'isolement total de chaque sous-groupe de boites quantiques (QD) du groupe cible (GC) de boites quantiques (QD) de sorte que l'étape (1 E3) de détermination de l'état de charge se fait alors que le premier sous-groupe et le deuxième sous-groupe du groupe cible (GC) de boite quantique (QD) est dans un régime totalement isolé.

6. Procédé (100) selon l'une des revendications précédentes dans lequel, durant l'étape (1E1) d'isolement, l'étape (1E2) de manipulation et/ou, le cas échéant, l'étape (1 E3) de détermination de l'état de charge, les boites quantiques (QD) n'appartenant pas à un groupe cible (GC) sont dans un régime totalement isolé.

7. Procédé (200) de détermination de la position du régime totalement isolé entre une première boite quantique (QD1) et une deuxième boite quantique boite quantique (QD2), la configuration du système constitué par la première boite quantique QD1 et la deuxième boite quantique (QD2) pouvant être **caractérisé par** un premier paramètre $\Gamma$ relatif à la barrière de potentiel séparant les deux boites quantiques du système et par un deuxième paramètre $\varepsilon$ relatif à la différence en énergie entre l'état fondamental de la première boite quantique et l'état fondamental de la deuxième boite quantique, le premier et le deuxième paramètres pouvant être modifiés à l'aide d'au moins deux tensions appliquées sur des grilles, ledit système pouvant prendre soit l'état de charge (1,1), soit l'état de charge (0,2) soit l'état de charge (2,0) où l'état de charge ($n_{QD1}$,$n_{QD2}$) correspond à un état de charge $n_{QD1}$ pour la première boite quantique (QD1) et un état de charge $n_{QD2}$ pour la deuxième boite quantique (QD2), le procédé comprenant, pour une pluralité de configurations finales :

- pour une pluralité de configuration initiale correspondant à une distribution d'état de charge connue, dite distribution des états de charge initiale :

  ▪ une étape (2E1) d'initialisation du système dans une première configuration correspondant à la configuration initiale considérée ;
  ▪ une étape (2E2) de diminution du premier paramètre $\Gamma$, le système étant dans une deuxième configuration, dite configuration intermédiaire à l'issue de cette étape, la valeur du premier paramètre $\Gamma$ de la configuration intermédiaire étant égale à la valeur du premier paramètre $\Gamma$ de la configuration finale considéré ;
  ▪ une étape (2E3) de variation du deuxième paramètre $\varepsilon$, la valeur du premier paramètre étant conservée lors de cette étape, le système étant dans une troisième configuration, correspondant à la configuration finale considérée à l'issue de cette étape ;
  ▪ une étape (2E4) de détermination de l'état de charge du système dans la configuration finale ;

- une étape (2E5) de détermination de la distribution des états de charge mesurés dans la configuration finale ;
- une étape (2E6) de comparaison de la distribution des états de charge initiale à la distribution des états de charges mesurés dans la configuration finale, la valeur du premier paramètre $\Gamma$ de la configuration finale correspondant à un régime totalement isolé si les deux distributions sont sensiblement identiques.

8. Dispositif quantique comprenant une matrice (MQ) de qubit (QB) et des moyens configurés pour mettre en œuvre un procédé selon l'une des revendications précédentes.

9. Programme d'ordinateur comprenant des instructions qui, lorsque le programme est exécuté par un ordinateur, conduisent celui-ci à mettre en œuvre le procédé selon l'une des revendication 1 à 6.

10. Support de données lisible par ordinateur, sur lequel est enregistré le programme d'ordinateur selon la revendication précédente.

[Fig. 1]

## 100

```
┌─────────────┐
│             │
│     1E1     │
│             │
└──────┬──────┘
       │
       ▼
┌─────────────┐
│             │
│     1E2     │
│             │
└──────┬──────┘
       ┊
       ▼
┌ ─ ─ ─ ─ ─ ─ ┐
│             │
     1E3
│             │
└ ─ ─ ─ ─ ─ ─ ┘
```

[Fig. 2]

## MQ      QD

[Fig. 3]

QD

[Fig. 4A]

QD1    QD2

[Fig. 4B]

[Fig. 5]

EP 4 020 335 A2

[Fig. 6]

[Fig. 7A]

19

[Fig. 7B]

[Fig. 8]

200

```
┌──────────┐
│   2E1    │
└──────────┘
      │
      ▼
┌──────────┐
│   2E2    │
└──────────┘
      │
      ▼
┌──────────┐
│   2E3    │
└──────────┘
      │
      ▼
┌──────────┐
│   2E4    │
└──────────┘
      │
      ▼
┌──────────┐
│   2E5    │
└──────────┘
      │
      ▼
┌──────────┐
│   2E6    │
└──────────┘
```

[Fig. 9]

[Fig. 10]

[Fig. 11]

[Fig. 12]

[Fig. 13]

[Fig. 14]

[Fig. 15]

[Fig. 16]

P(1,1)

Temps
d'attente (ua)

[Fig. 17]

MQ

QDC

[Fig. 18]

## MQ

QD2

QD1

[Fig. 19]

[Fig. 20]

**RÉFÉRENCES CITÉES DANS LA DESCRIPTION**

**Documents brevets cités dans la description**

- EP 3401848 A1
- US 20200127096 A1

- FR 306629 A1

**Littérature non-brevet citée dans la description**

- **NAZAROV, Y. ; BLANTER, Y.** Quantum Transport: Introduction to Nanoscience. Cambridge University Press, 2009